# EUROPÄISCHE PATENTANMELDUNG

(11) **EP 0 840 432 A2**
(43) Veröffentlichungstag der Anmeldung: **06.05.1998**
(21) Anmeldenummer: 97402572.8
(22) Anmeldetag: 29.10.1997
(51) Int. Cl.: H02M 7/06

(54) **Schaltungsanordnung zur Erzeugung einer Gleichspannung**

(30) Priorität: 30.10.1996 DE 19643822
(71) Anmelder: ALCATEL ALSTHOM COMPAGNIE GENERALE D'ELECTRICITE, 75008 Paris (FR)
(72) Erfinder: Ocker, Johannes, Ing. (grad.), 30453 Hannover (DE)
(74) Vertreter: Döring, Roger, Dipl.-Ing.

(57) **Zusammenfassung**

Es wird eine Schaltungsanordnung zur Erzeugung einer Gleichspannung aus einer Wechselspannung angegeben, bei welcher die Wechselspannung mittels eines Gleichrichterelements gleichgerichtet wird, an dessen Ausgang die Gleichspannung ansteht. Zur Erfassung auch kleinerer Wechselspannungen wird die Wechselspannung zunächst einer Gleichspannung überlagert und dann einer Schaltung mit zwei parallelen, von zumindest annähernd gleichgroßen Strömen durchflossenen Zweigen (Z1,Z2) zugeführt, in denen Gleichrichterelemente (D1,D2) mit identischem elektrischem Verhalten angeordnet sind. In einem der beiden Zweige (Z2) wird nur die Gleichspannung durchgelassen, während im anderen Zweig (Zl) die Gleichspannung und die überlagerte Wechselspannung durchgelassen werden. Beide Zweige (Z1,Z2) sind an einen Differenzbilder (DB) angeschlossen, in welchem die Differenz der beiden von den Zweigen (Z1,Z2) getrennt zugeführten Spannungen gebildet wird und an dessen Ausgang (A) eine der Amplitude der Wechselspannung entsprechende Gleichspannung ansteht.

## Beschreibung

Die Erfindung bezieht sich auf eine Schaltungsanordnung zur Erzeugung einer Gleichspannung aus einer Wechselspannung, bei welcher die Wechselspannung mittels eines Gleichrichterelements gleichgerichtet wird, an dessen Ausgang die Gleichspannung ansteht (DE-Buch von D. Nührmann, "Das große Werkbuch Elektronik", 1994 Franzis-Verlag GmbH, Seite 1174).

Eine derartige Schaltungsanordnung wird zur Bestimmung der Amplitude von Wechselspannungen verwendet. Ein besonderes Einsatzgebiet ist beispielsweise die Messung des Pegels von Nachrichtensignalen. Als Gleichrichterelemente werden nahezu ausschließlich Halbleiterdioden eingesetzt. Im folgenden wird der Einfachheit halber statt des Wortes "Gleichrichterelement" das Wort "Diode" verwendet. Dioden aus unterschiedlichen Chargen haben oft fertigungsbedingte unterschiedliche Flußspannungen, d.h. der Spannungsabfall über den Dioden kann fertigungsbedingt schwanken. Die Flußspannung ist außerdem von Temperaturschwankungen und anderen Umgebungseinflüssen sowie von dem durch die Dioden fließenden Strom abhängig. Die beschriebenen "Störgrößen" können das Ergebnis der Spannungsmessung verfälschen. Die Messung ist oft nicht reproduzierbar. Das macht sich besonders bei kleinen Wechselspannungen störend bemerkbar, die beispielweise in der Größenordnung von 100 mV liegen.

Der Erfindung liegt die Aufgabe zugrunde, die eingangs geschilderte Schaltungsanordnung so zu gestalten, daß sie auch bei niedrigen Wechselspannungen reproduzierbare Ergebnisse liefert.

Diese Aufgabe wird gemäß der Erfindung dadurch gelöst,
- daß die Wechselspannung zunächst einer Gleichspannung überlagert und einer Schaltung mit zwei parallelen, von zumindest annähernd gleichgroßen Strömen durchflossenen Zweigen zugeführt wird, in denen je eine Diode mit identischem elektrischem Verhalten angeordnet sind,
- daß in einem der beiden Zweige nur die Gleichspannung durchgelassen wird, während im anderen Zweig die Gleichspannung und die überlagerte Wechselspannung durchgelassen werden und
- daß beide Zweige an einen Differenzbilder angeschlossen sind, in welchem die Differenz der beiden von den Zweigen getrennt zugeführten Spannungen gebildet wird und an dessen Ausgang eine der Amplitude der Wechselspannung entsprechende Gleichspannung ansteht.

Bei dieser Schaltungsanordnung wirken sich Temperaturschwankungen und andere Umgebungseinflüsse auf die beiden Zweige der Schaltung in gleicher Weise aus. Durch die als "Träger" für die Wechselspannung dienende Gleichspannung ist sichergestellt, daß in beiden Zweigen der Schaltung ausreichend hohe Ströme fließen. Da diese Ströme zumindest annähernd gleich groß sind und die beiden Dioden sich elektrisch identisch verhalten, wird also die Gleichspannung in beiden Zweigen gegebenfalls in gleichem Sinne verändert. Die jeweiligen Anteile der Gleichspannung heben sich in dem Differenzbilder auf. Es bleibt nur der von der gleichgerichteten Wechselspannung herrührende Teil der Gleichspannung übrig. Die am Ausgang des Differenzbilders anstehende Gleichspannung ist ein reproduzierbarer Wert für die Amplitude der dem Eingang der Schaltung aufgegebenen überlagerten Wechselspannung.

Vorteilhafte Ausgestaltungen der Erfindung gehen aus den Unteransprüchen hervor.

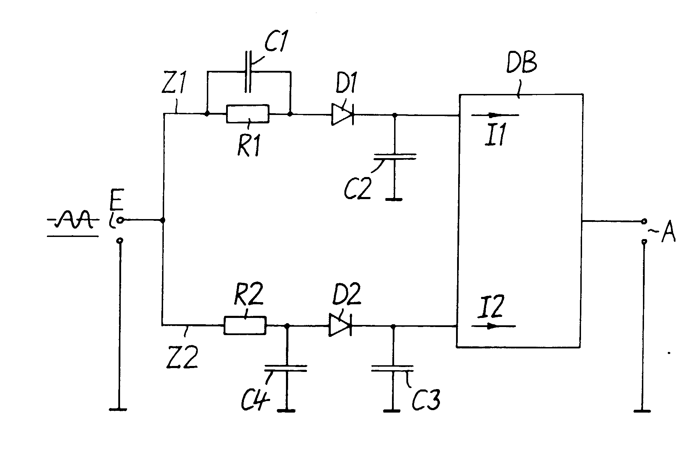

Ein Ausführungsbeispiel des Erfindungsgegenstandes wird anhand der in der Zeichnung schematisch dargestellten Schaltung erläutert:

Die Schaltung hat einen Eingang E, von dem zwei parallele Zweige Z1 und Z2 ausgehen Im Zweig Z1 liegen ein ohm'scher Widerstand R1 und eine Diode D1 in Reihe. Parallel zum Widerstand R1 ist ein Kondensator C1 angeordnet Im Zweig Z2 liegen ein ohm'scher Widerstand R2 und eine Diode D2 in Reihe.

Die Widerstände R1 und R2 liegen jeweils zwischen dem Eingang E der Schaltung und der jeweiligen Diode D1 bzw. D2. Sie sind gleich groß. Die Dioden Dl und D2 verhalten sich elektrisch identisch. Es handelt sich beispielweise um Germanium - oder Siliziumdioden. Sie sind in der Schaltung vorzugsweise räumlich direkt nebeneinander angeordnet. In bevorzugter Ausführungsform sind die beiden Dioden D1 und D2 in einem gemeinsamen Gehäuse untergebracht.

Die Zweige Z1 und Z2 der Schaltung sind an einen Differenzbilder DB angeschlossen. Der Differenzbilder DB kann auch als "Subtrahierer" oder als "Summierpunkt" bezeichnet werden. Er ist beispielweise als Operationsverstärker mit entsprechender Zusatzbeschaltung ausgeführt. Der Ausgang der Schaltung ist mit A bezeichnet. Die Kondensatoren C2 und C3 dienen der Glättung der an den Dioden D1 und D2 anstehenden Gleichspannung. Der Kondensator C4 bildet zusarnmen mit dem Widerstand R2 einen Tiefpaß zur Einstellung des Mittelwerts der am Eingang E anliegenden Spannung.

Die Schaltungsanordnung arbeitet wie folgt:

Eine Wechselspannung, deren Amplitude gemessen werden soll, wird beispielweise einer positiven Gleichspannung überlagert und dem Eingang E der aus der Zeichnung ersichtlichen Schaltung aufgegeben. Bei der Wechselspannung handelt es sich beispielweise um ein Nachrichtensignal, dessen Pegel zur Veranlassung weiterer Maßnahmen bekannt sein muß. Sie könnte bei entsprechender Polung auch einer negativen Gleichspannung überlagert werden.

Der Zweig Z2 ist für die Wechselspannung gesperrt. Er ist also nur für die Gleichspannung durchlässig, die einen Strom 12 hervorruft. Wegen des Kondensators C1 ist der Zweig Z1 auch für die Wechselspannung durchlässig. Sie wird von der Diode D1 gleichgerichtet. Im Zweig Z1 fließt der Strom I1. Die Ströme I1 und I2 sind zumindest annähernd gleich groß. Sie sind in bevorzugter Ausführungsform identisch.

Die an den Kondensatoren C2 und C3 anstehenden, an den Dioden D1 und D2 abfallenden Gleichspannungen werden dem Differenzbilder DB aufgegeben. Die von der Gleichspannung herrührenden Anteile der Gleichspannungen sind gleich groß Sie heben sich gegenseitig auf Am Ausgang A des Differenzbilders DB steht damit eine Gleichspannung an, deren Betrag gleich der Amplitude der Wechselspannung bzw. dem Pegel des Nachrichtensignals ist.

## Patentansprüche

1. Schaltungsanordnung zur Erzeugung einer Gleichspannung aus einer Wechselspannung, bei welcher die Wechselspannung mittels eines Gleichrichterelements gleichgerichtet wird, an dessen Ausgang die Gleichspannung ansteht, dadurch gekennzeichnet,
- daß die Wechselspannung zunächst einer Gleichspannung überlagert und einer Schaltung mit zwei parallelen, von zumindest annähernd gleichgroßen Strömen durchflossenen Zweigen (Z1,Z2) zugeführt wird, in denen Gleichrichterelemente (D1,D2) mit identischem elektrischem Verhalten angeordnet sind,
- daß in einem der beiden Zweige (Z2) nur die Gleichspannung durchgelassen wird, während im anderen Zweig (Z1) die Gleichspannung und die überlagerte Wechselspannung durchgelassen werden und
- daß beide Zweige (Z1,Z2) an einen Differenzbilder (DB) angeschlossen sind, in welchem die Differenz der beiden von den Zweigen (Z1,Z2) getrennt zugeführten Spannungen gebildet wird und an dessen Ausgang (A) eine der Amplitude der Wechselspannung entsprechende Gleichspannung ansteht.

2. Schaltungsanordnung nach Anspruch 1, dadurch gekennzeichnet, daß in beiden Zweigen (Z1,Z2) der Schaltung zwischen der Einspeisung der Spannung und den Gleichrichterelementen (D1,D2) in Reihe mit denselben liegende, identische ohm'sche Widerstände (R1,R2) eingeschaltet sind.

3. Schaltungsanordnung nach Anspruch 2, dadurch gekennzeichnet, daß in einem Zweig (Z1) parallel zu dem ohm'schen Widerstand (R1) ein Kondensator (C1) liegt.

4. Schaltungsanordnung nach einem der Ansprüche 1 bis 3, dadurch gekennzeichnet, daß die beiden Gleichrichterelemente (D1,D2) räumlich direkt nebeneinander angeordnet sind, vorzugsweise in einem gemeinsamen Gehäuse.

5. Schaltungsanordnung nach einem der Ansprüche 1 bis 4, dadurch gekennzeichnet, daß die Gleichrichterelemente (D1,D2) als Dioden ausgebildet sind.
